Europäisches Patentamt

European Patent Office

Office européen des brevets

(11) Numéro de publication : **0 419 332 B1**

# (12) FASCICULE DE BREVET EUROPEEN

(45) Date de publication du fascicule du brevet :
**08.06.94 Bulletin 94/23**

(51) Int. Cl.$^5$ : **H01R 13/658, H05K 9/00**

(21) Numéro de dépôt : **90402546.7**

(22) Date de dépôt : **14.09.90**

(54) **Ensemble de blindage pour un bloc collecteur relié à un équipement électrique placé à l'intérieur d'un châssis.**

(30) Priorité : **19.09.89 FR 8912288**

(43) Date de publication de la demande :
**27.03.91 Bulletin 91/13**

(45) Mention de la délivrance du brevet :
**08.06.94 Bulletin 94/23**

(84) Etats contractants désignés :
**DE ES FR GB IT**

(56) Documents cités :
**DE-U- 8 517 334**
**US-A- 3 476 983**
**US-A- 4 550 960**
**US-A- 4 632 476**
**US-A- 4 738 637**

(73) Titulaire : **BULL S.A.**
**Tour BULL,**
**1, place Carpeaux**
**F-92800 Puteaux (FR)**

(72) Inventeur : **César, Charles**
**5, rue Elsa Triolet**
**F-38400 Saint Martin D'Hères (FR)**

(74) Mandataire : **Debay, Yves et al**
**BULL S.A.**
**Tour BULL Cédex 74**
**PC/TB2803**
**F-92039 Paris La Défense (FR)**

EP 0 419 332 B1

Jouve, 18, rue Saint-Denis, 75001 PARIS

## Description

La présente invention se rapporte à un ensemble de blindage pour un bloc collecteur relié à un équipement électrique placé à l'intérieur d'un châssis.

Dans la technique de construction des équipements électroniques utilisés pour les télécommunications et, plus particulièrement, pour le traitement des informations, il est fait un large usage d'ensembles électriques plus au moins complexes qui, tels que les enregistreurs électriques de mesure ou les circuits électroniques fonctionnant par impulsions par exemple, sont particulièrement sensibles aux effets perturbateurs causés par les rayonnements électromagnétiques qui sont engendrés par d'autres circuits électriques qui ne font pas partie de ces ensembles. C'est pourquoi ces ensembles électriques, afin d'être protégés contre ces rayonnements parasites, sont généralement enfermés à l'intérieur d'un châssis métallique qui sert à la fois de support mécanique et de blindage pour cet ensemble électrique. Chacun de ces ensembles électriques se compose habituellement, d'une part d'un équipement central de commande qui, constitué le plus souvent par une ou plusieurs cartes à circuits imprimés munies de composants électroniques, est logé dans un bâti métallique fixe solidaire du châssis, d'autre part de un ou plusieurs appareils périphériques qui, tels que des dispositifs enregistreurs ou des lecteurs de disques par exemple, sont montés dans des boîtiers métalliques amovibles pouvant prendre place à l'intérieur de ce châssis. Dans ce mode d'arrangement, chaque appareil périphérique est relié à l'équipement central de commande au moyen d'un câble multiconducteur blindé qui, fixé à l'une de ses extrémités, aux circuits électriques propres de cet appareil, est pourvu, à son autre extrémité, d'un connecteur blindé qui permet de raccorder ce câble aux circuits électriques de cet équipement de commande. A cet effet, l'équipement central de commande est équipé d'un bloc collecteur du type de celui qui a été décrit dans le brevet français N° 2.566.193 (ce brevet correspondant à la demande de brevet britannique publiée sous le N° 2.160.719), ce bloc collecteur étant fixé sur une carte à circuit et comprenant un corps isolant allongé présentant une face d'accouplement qui, perpendiculaire à cette carte, est destinée à recevoir plusieurs connecteurs blindés. Ce bloc collecteur est revêtu, sur sa face supérieure et sur ses deux faces latérales adjacentes à sa face d'accouplement, d'un capot métallique qui, dépassant les extrémités des éléments de contact qui partent de cette face d'accouplement, sert de blindage pour ces éléments. Dans ce but, ce capot est pourvu de pattes métalliques qui, traversant la carte à circuits, sont soudées sur des zones conductrices formées sur l'une des faces de cette carte, ces zones conductrices étant elles-mêmes mises électriquement à la terre. Lorsque l'ensemble constitué par cette carte à circuits et ce bloc collecteur est placé à l'intérieur d'un châssis de blindage, cette mise à la terre est obtenue en reliant simplement ces zones conductrices aux pièces métalliques qui, montées à l'intérieur du châssis, sont prévues pour supporter cet ensemble. Ce châssis de blindage est naturellement pourvu d'une ouverture, en face de laquelle est positionné le bloc collecteur, cette ouverture ayant des dimensions supérieures à celles de ce bloc collecteur et étant destinée à permettre aux connecteurs blindés d'être introduits, sans être gênés, par l'opérateur, à l'intérieur du châssis, afin d'être accouplés au bloc collecteur. Par ailleurs, le capot métallique qui recouvre le bloc collecteur est muni en outre de doigts élastiques conducteurs qui, lorsqu'un connecteur blindé est accouplé au bloc collecteur, viennent au contact de l'élément de blindage de ce connecteur. Dans ces conditions, cet élément de blindage, de même que la gaine de blindage du câble qui est solidaire de ce connecteur, est mis à la terre par l'intermédiaire, successivement, de ces doigts élastiques, du capot métallique, des zones conductrices de la carte à circuits, des pièces métalliques de fixation de cette carte au châssis et, enfin, des conducteurs qui relient normalement ce châssis à la terre. Cette manière de faire exige naturellement que la carte à circuits comporte, en plus des conducteurs habituels utilisés pour la transmission des signaux électriques ou pour l'application de potentiels électriques de valeurs données, des zones métalliques particulières qui permettent au capot de blindage, d'une part d'être solidement fixé sur cette carte, d'autre part d'être raccordé électriquement au châssis. Mais la présence de ces zones métalliques a cependant pour inconvénient de nécessiter, sur la surface de la carte, une place relativement importante, ce qui conduit, soit à augmenter notablement les dimensions de cette carte, soit à accroître fortement la densité des autres conducteurs implantés sur celle-ci. En outre, ces zones métalliques, qui sont situées à proximité de ces autres conducteurs, présentent le risque d'être mises involontairement en contact avec ceux-ci et de provoquer ainsi des courts-circuits. De plus, dans le cas où le bloc collecteur est prévu pour recevoir un nombre conséquent de connecteurs, c'est-à-dire, par exemple, plus de six connecteurs, le capot de blindage ne suffit plus à assurer une bonne protection des éléments de contact de ce bloc, surtout si, pour certaines applications particulières, plusieurs connecteurs, normalement accouplés, les uns à côté des autres, à ce bloc collecteur, viennent à être retirés de celui-ci. Enfin, la portion conductrice de circuit qui est constituée par l'élément de blindage de chaque connecteur, les doigts élastiques, le capot métallique, les zones conductrices et les pièces métalliques de fixation de la carte au châssis, est située pratiquement entièrement à l'intérieur du châssis. Il en résulte que les courants électriques parasites qui prennent naissance dans la gaine de blindage de chaque câble, sous l'action des rayonnements électromagnétiques qui règnent à l'extérieur du châssis, engendrent lorsqu'ils passent dans cette portion conductrice de circuit afin de s'écouler naturellement vers la terre, un rayonnement électromagnétique qui est d'autant plus important que l'aire de la boucle constituée par cette portion conductrice est plus grande et que la fréquence de ces courants parasites est plus élevée. Ce rayonnement électromagnétique qui est produit par cette portion conductrice à l'intérieur du châssis, risque alors de perturber les circuits électriques que ce châssis était censé protéger.

La présente invention remédie aux inconvénients de la technique antérieure et propose un ensemble de blindage qui, destiné à un bloc collecteur conçu pour réaliser la liaison électrique entre une pluralité de connecteurs blindés, d'une part, et un équipement électrique placé à l'intérieur d'un châssis, d'autre part, permet, sans avoir recours à une carte à circuits équipée de zones métalliques particulières, de protéger efficacement, contre les rayonnements électromagnétiques extérieurs, les éléments de contact de ce bloc collecteur, et cela même lorsque le nombre des connecteurs qui sont accouplés à ce bloc est relativement réduit.

Plus précisément, la présente invention concerne un ensemble de blindage pour un bloc collecteur relié à un équipement électrique placé à l'intérieur d'un châssis, ce bloc collecteur comprenant un corps isolant allongé présentant une face d'accouplement destinée à recevoir plusieurs connecteurs complémentaires blindés, ce corps isolant étant pourvu d'éléments de contact d'un premier type qui, raccordés aux circuits dudit équipement électrique, sont établis de manière à pouvoir être connectés à des éléments de contact d'un second type de chacun desdits connecteurs complémentaires, cet ensemble de blindage étant caractérisé en ce que, ledit corps isolant étant positionné, à l'intérieur dudit châssis, de telle sorte que ses éléments de contact passent au travers d'une ouverture pratiquée dans une plaque d'enceinte métallique de ce châssis, il comporte :

- d'une part deux parois métalliques recouvrant chacune respectivement chacune des deux faces de plus grandes dimensions qui, sur ce corps isolant, sont adjacentes à ladite face d'accouplement, ces deux parois s'étendant, de l'intérieur vers l'extérieur dudit châssis, de façon que leurs bords extérieurs qui sont parallèles à ladite plaque d'enceinte dépassent les extrémités des éléments de contact dudit corps isolant,
- d'autre part une pluralité de cloisons métalliques disposées entre ces deux parois, perpendiculairement à celles-ci et à ladite face d'accouplement, ces cloisons s'étendant chacune, à partir de cette face, jusqu'aux dits bords extérieurs desdites parois, de manière à constituer avec ces parois une pluralité de cavités de réception de connecteurs complémentaires blindés, chaque cavité étant dimensionnée de telle sorte que les parois et cloisons qui la délimitent viennent au contact du blindage du connecteur complémentaire qui est introduit dans cette cavité, cet ensemble de blindage étant relié électriquement à ladite plaque d'enceinte par l'intermédiaire d'un élément conducteur ne passant pas à l'intérieur de ce châssis.

L'invention sera mieux comprise et d'autres buts, détails et avantages de celle-ci apparaîtront mieux dans la description suivante, donnée à titre d'exemple non limitatif, et en se référant aux dessins annexés sur lesquels :

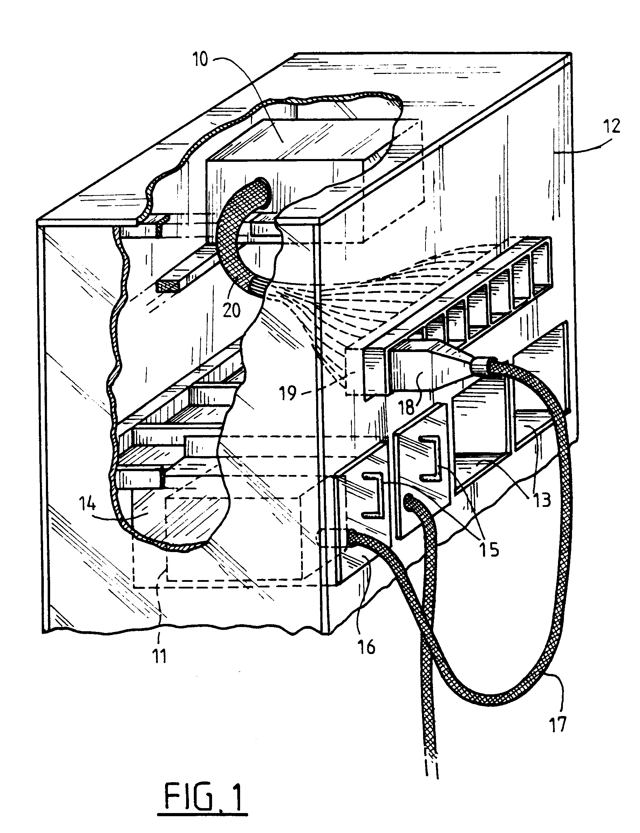

- La figure 1 est une vue schématique en perspective montrant un châssis-support qui, équipé d'un bloc collecteur muni d'un ensemble de blindage réalisé selon l'invention, est établi pour recevoir des boîtiers amovibles contenant des appareils électriques destinés à être connectés, par l'intermédiaire de ce bloc collecteur, à un équipement de commande logé à l'intérieur de ce châssis-support,

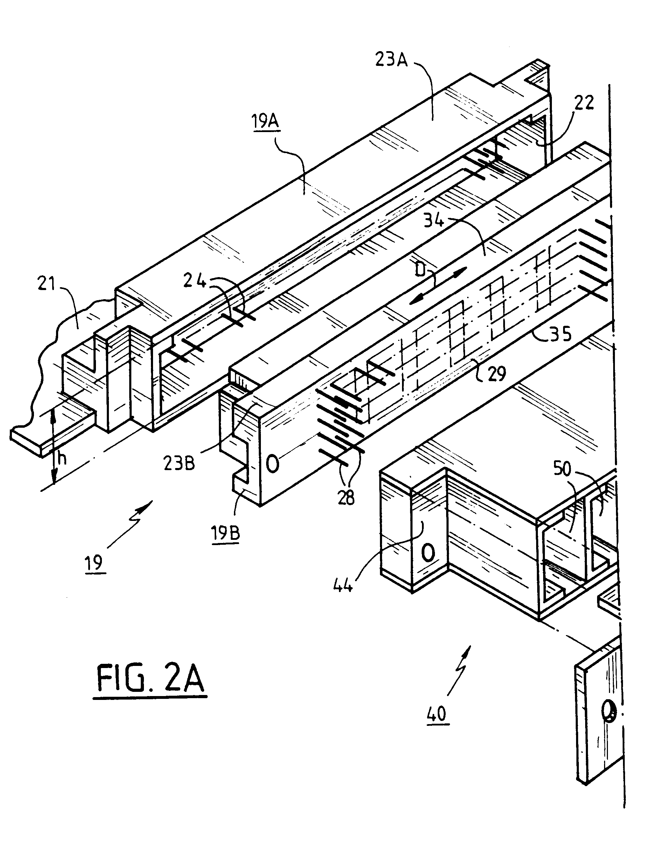

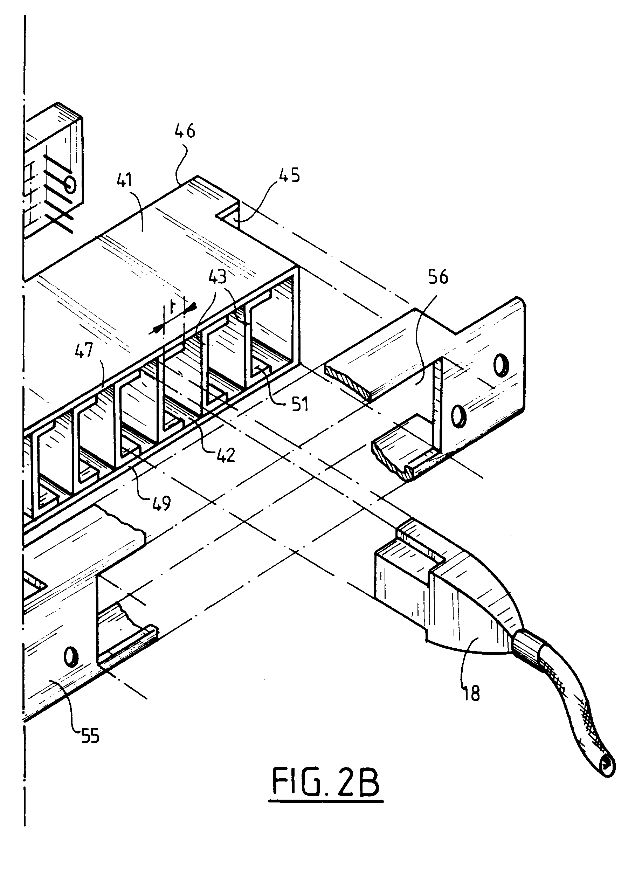

- Les figures 2A et 2B forment, lorsqu'elle sont assemblées, une vue en perspective, avec parties éclatées, montrant la constitution du bloc collecteur et de l'ensemble de blindage qui équipent le châssis-support représenté sur la figure 1,

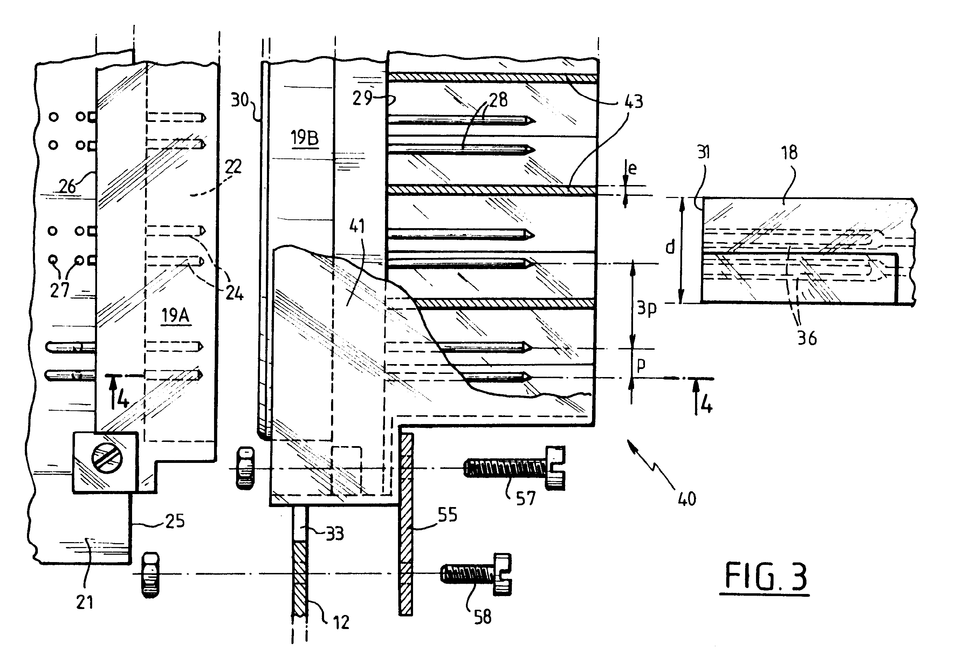

- La figure 3 est une vue en plan avec parties arrachées montrant la façon dont sont assemblées et positionnées les différentes pièces constitutives du bloc collecteur et de l'ensemble de blindage lors de leur montage dans le châssis-support qui est représenté sur la figure 1, et

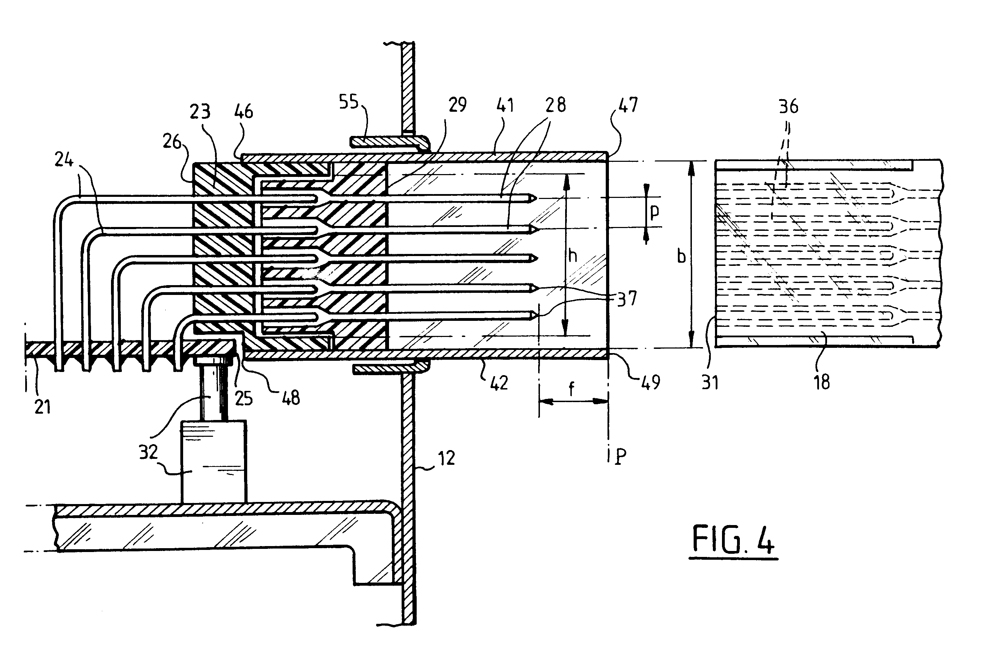

- La figure 4 est une vue en coupe, suivant un plan passant par une ligne indiquée par 4-4 sur la figure 3, montrant les positions des éléments de contact du bloc collecteur par rapport aux éléments de blindage lorsque toutes les pièces constitutives de ce bloc collecteur et de l'ensemble de blindage ont été montées dans le châssis-support de la figure 1.

Le châssis-support qui est montré en partie sur la figure 1 est destiné à servir à la fois de support mécanique et de blindage électromagnétique à un ensemble électrique constitué, d'une part d'un équipement électrique de commande 10, d'autre part d'une pluralité d'appareils électriques périphériques, dont l'un seulement 11 a été schématiquement représenté en traits interrompus sur la figure 1, ces appareils périphériques étant commandés par cet équipement de commande 10 et étant, à cet effet, reliés à celui-ci, d'une manière qui sera indiqué plus loin. Le châssis-support, qui est de forme parallélépipédique, comporte des plaques d'enceinte métalliques qui sont assemblées entre elles, de manière connue, au moyen de cornières et d'entretoises, ces plaques d'enceinte assurant la délimitation de l'espace intérieur de ce châssis. L'une, 12, des quatre plaques d'enceinte verticales de ce châssis-support est pourvue d'ouvertures 13 donnant accès à des compartiments dans lesquels peuvent être engagés des tiroirs 14 contenant chacun l'un des appareils périphériques 11. A cet effet, chaque tiroir est muni d'une poignée 15 qui, fixée sur la paroi avant 16 de ce tiroir, permet à l'opérateur de saisir ce tiroir, soit pour le mettre en place dans l'un des compartiments du châssis-support, soit pour le retirer de ce compartiment. L'appareil 11 qui se trouve dans chaque tiroir est raccordé à l'équipement de commande 10 au moyen d'un câble multiconducteur blindé 17 qui, relié, à l'une de ses extrémités, aux circuits électriques de cet appareil, passe au travers d'un orifice pratiqué dans la paroi avant de ce tiroir, ce câble 17 étant pourvu, à son autre extrémité, d'un connecteur blindé 18 qui peut être accouplé à un bloc collecteur 19 disposé en face d'une ouverture de la plaque d'enceinte 12 du châssis-support, ce bloc collecteur 19 étant lui-même relié à l'équipement de commande 10. Dans l'exemple de réalisation illustré sur la figure 1, la liaison entre le bloc collecteur 19 et l'équipement de commande 10 est établie à l'aide d'un câble multiconducteur 20, mais il est entendu que, comme on le verra d'ailleurs plus loin, cette liaison pourrait être établie au moyen d'une carte à circuit. De même, bien que, sur la figure 1, l'équipement de commande 10 ait été représenté symboliquement sous forme d'un bloc parallélépipédique, on comprendra que, dans la réalité, cet équipement est constitué d'un ensemble de cartes à circuits imprimés montées, de façon connue, dans des glissières ou des rainures disposées à l'intérieur d'une baie du châssis-support. A titre d'exemple, un montage de ce type a notamment été décrit et représenté dans le brevet des Etats-Unis d'Amérique N° 3.476.983.

On va maintenant, en se référant aux figures 2A, 2B, 3 et 4, décrire la structure du bloc collecteur 19 qui a été schématiquement représenté sur la figure 1. Le bloc collecteur qui est illustré sur les figures 2A et 2B se compose de deux parties, à savoir une partie principale 19A qui est rendue solidaire d'une carte à circuit 21 servant à établir la liaison électrique entre ce bloc collecteur et l'équipement de commande 10, et une partie complémentaire 19B prévue pour être emboîtée dans un évidement 22 de la partie principale 19A. La partie principale 19A comprend un corps allongé 23A, réalisé en un matériau isolant, et une pluralité de broches de contact 24 qui, traversant le corps isolant 23A, font saillie, à l'une de leurs extrémités, à l'intérieur de l'évidement 22 de ce corps. Les figures 3 et 4 montrent que ce corps isolant 23A est fixé le long d'un bord 25 de la carte à circuit 21, de telle sorte que les parois de ce corps qui délimitent l'évidement 22 se trouvent en surplomb par rapport à ce bord 25. Les figures 3 et 4 montrent en outre que les portions des broches de contact 24 qui dépassent de la face 26 de ce corps qui est opposée à cet évidement 22 sont coudées à angle droit de manière à permettre à ces portions, lors du montage de la partie principale 19A sur la carte 21, d'être engagées dans des trous 27 de cette carte afin d'être soudées aux conducteurs portés par cette carte. La partie complémentaire 19B du bloc collecteur comprend, ainsi qu'on peut le voir sur les figures 2A, 3 et 4, un corps allongé 23B, réalisé en un matériau isolant, et une pluralité d'éléments de contact 28 qui, orientés suivant une direction perpendiculaire à la direction d'allongement D du corps 23B, traversent ce corps pour, d'une part faire saillie sur une face d'accouplement 29 de ce corps, et pour, d'autre part, déboucher sur la face 30 de ce corps qui est parallèle et opposée à cette face d'accouplement 29. Chacun de ces éléments de contact est pourvu, à son extrémité située du côté de la face 30, d'une partie évidée dans laquelle s'engage, lorsque la partie complémentaire 19B est introduite dans l'évidement 22, la portion d'une broche de contact 24 faisant saillie dans cet évidement.

Il est utile d'indiquer que la face d'accouplement 29 est destinée à recevoir des connecteurs blindés semblables à celui qui est désigné par la référence 18 sur la figure 1. Sans entrer dans les détails, on considèrera que chacun de ces connecteurs comporte, dans l'exemple décrit, dix éléments de contact 36 (figures 3 et 4) établis pour être connectés chacun à chacun des éléments de contact 28 du corps 23B. On considèrera en outre que ces dix éléments de contact, qui sont ici de type femelle, sont disposés suivant deux colonnes, chaque colonne comprenant ainsi cinq éléments de contact, ces éléments de contact étant, dans chaque colonne, répartis à un pas d'espacement p égal à la distance d'écartement des deux colonnes. En conséquence, ainsi qu'on peut le voir sur les figures 2A, 3 et 4, les éléments de contact 28 du corps 23B, qui sont de type mâle, sont arrangés, sur la face d'accouplement 29 de ce corps, par groupes de dix éléments de contact, les éléments de contact 28 de chaque groupe étant disposés suivant deux colonnes écartées l'une de l'autre d'une distance p (figure 3), chacune de ces colonnes comportant cinq éléments de contact répartis à un pas d'espacement p (figure 4). Par ailleurs, les groupes d'éléments de contact sont, comme le montre la figure 3, séparés l'un de l'autre par une distance égale à 3p. Cette manière de faire permet d'utiliser, pour la constitution des parties 19A et 19B du bloc collecteur, des connecteurs standarts du commerce dont les logements des éléments de contact sont disposés, sur les faces d'accouplement de ces connecteurs, suivant cinq lignes et n colonnes, ces logements étant, tant dans ces lignes que dans ces colonnes, espacés régulièrement les uns des autres d'une même distance p, les éléments de contact n'étant implantés que dans une partie seulement de ces logements, afin de former un arrangement d'éléments de contact dont la disposition soit celle qui a été indiquée ci-dessus.

Ainsi qu'on peut le comprendre en se référant aux figures 2A, 2B, 3 et 4, chaque connecteur blindé 18 présente une face d'accouplement 31 qui a pratiquement la forme d'un rectangle, de dimensions b et d, et il est orienté, lorsqu'il doit être accouplé à la partie 19B du bloc collecteur, de telle sorte que la longueur b de cette face d'accouplement soit perpendiculaire au plan de la carte à circuits 21. On peut observer par ailleurs, en se référant aux figures 2A et 4, que l'évidement 22 de la partie 19A de ce bloc collecteur présente, dans une direction perpendiculaire au plan de cette carte 21, une dimension h qui est inférieure à la longueur b de la face d'accouplement 31 du connecteur blindé 18. On voit donc que, en l'absence de la partie 19B, il serait matériellement impossible d'accoupler directement chacun des connecteurs blindés à la partie 19A. Au contraire, du fait que la face d'accouplement 29 de la partie complémentaire 19B ne se trouve pas à l'intérieur d'une cavité faiblement dimensionnée, cette partie 19B peut aisément être accouplée à ces connecteurs blindés et assurer ainsi le raccordement électrique de ces connecteurs aux circuits de la carte 21.

Il faut encore signaler que, bien que, dans l'exemple décrit, le bloc collecteur 19 soit constitué de deux parties 19A et 19B emboîtables l'une dans l'autre et formées à partir de composants du commerce, ce bloc collecteur pourrait également être réalisé en une seule pièce et comporter alors un seul corps isolant présentant une face d'accouplement établie pour recevoir les connecteurs blindés mentionnés ci-dessus, ce corps isolant étant pourvu d'éléments de contact réalisés de manière à pouvoir être reliés, à l'une de leurs extrémités, aux circuits de la carte 21, et à être mis en contact, à leur autre extrémité, avec les éléments de contact complémentaires qui équipent ces connecteurs blindés.

On peut remarquer, en se référant aux figures 3 et 4, que la carte à circuit 21, qui se trouve à l'intérieur du châssis-support, est rendue solidaire de ce châssis grâce à des pièces de fixation 32, de type connu, et qu'elle est disposée, en position horizontale, de telle sorte que, lorsque les deux parties 19A et 19B du bloc collecteur 19 sont assemblées l'une à l'autre, les éléments de contact 28 de ce bloc collecteur passent au travers d'une ouverture 33 de la plaque d'enceinte verticale 12, et font ainsi saillie à l'extérieur de ce châssis. Afin de permettre à ces éléments de contact d'être protégés efficacement contre les effets perturbateurs occasionnés par des rayonnements électromagnétiques engendrés par des appareils situés à l'extérieur du châssis-support, le bloc collecteur 19 est muni d'un ensemble de blindage 40 qui, comme le montrent les figures 2A et 2B, se compose essentiellement de deux parois métalliques 41 et 42, placées parallèlement l'une à l'autre et assemblées entre elles au moyen de plusieurs cloisons métalliques 43, ces cloisons étant montées les unes à la suite des autres, entre ces deux parois et perpendiculairement à celles-ci. En outre, deux pièces d'attache 44 et 45 sont prévues sur les deux parois 41 et 42, à proximité des cloisons extrêmes, afin de permettre à l'ensemble de blindage d'être fixé sur la partie 19B du bloc collecteur. Les deux parois métalliques 41 et 42 sont réalisées de telle sorte que, lorsque cet ensemble de blindage est ainsi fixé sur cette partie 19B, elles recouvrent, chacune respectivement, chacune des deux faces de plus grandes dimensions 34 et 35 qui, sur le corps isolant 23B, sont adjacentes à la face d'accouplement 29. La figure 4 montre la position qu'occupe chacune de ces deux parois par rapport à la plaque d'enceinte 12 lorsque, l'ensemble de blindage ayant été fixé sur la partie 19B du bloc collecteur, cette partie 19B est emboîtée dans la partie 19A de ce bloc collecteur. On voit, sur cette figure, que, dans l'ensemble de blindage ainsi positionné, la paroi métallique 41 présente deux bords 46 et 47 qui sont parallèles à la plaque d'enceinte 12 et dont l'un, 46, se trouve à l'intérieur du châssis-support, tandis que l'autre, 47, se trouve à l'extérieur. De même, la paroi métallique 42 présente deux bords 48 et 49 qui sont parallèles à la plaque d'enceinte 12 et dont l'un, 48, se trouve à l'intérieur de ce châssis, alors que l'autre, 49, se trouve à l'extérieur. Ces deux parois 41 et 42 sont dimensionnées de telle sorte que, comme on peut le remarquer sur la figure 4, leurs bords extérieurs respectifs 47 et 49 dépassent les extrémités 37 des éléments de contact 28 qui font saillie sur la face d'accouplement 29 du bloc collecteur, le plan P qui passe par ces deux bords 47 et 49 étant ainsi écarté de ces extrémités d'une distance f dont la valeur sera précisée plus loin. Par ailleurs, il faut signaler que, comme on peut aussi le voir sur cette figure, les deux parois 41 et 42 sont, au moins dans leurs parties s'étendant depuis la face d'accouplement 29 jusqu'à leurs bords extérieurs 47 et 49, écartées l'une de l'autre d'une distance qui est à peine supérieure à la longueur b de la face d'accouplement 31 de chacun des connecteurs blindés 18. On comprend, dans ces conditions, que, lorsqu'un connecteur blindé 18 est engagé entre ces deux parois 41 et 42 pour être accolé au bloc collecteur 19, le blindage qui entoure les faces de ce connecteur qui sont adjacentes à cette face d'accouplement 31 frotte légèrement sur ces deux parois et se trouve ainsi mis en contact avec ces dernières.

Si on revient maintenant aux figures 2A, 2B et 3, on voit que, lorsque l'ensemble de blindage 40 est fixé sur la partie 19B du bloc collecteur 19, les cloisons métalliques 43 sont disposées perpendiculairement à la face d'accouplement 29 de ce bloc collecteur, et qu'elles s'étendent chacune, à partir de cette face d'accouplement, jusqu'aux bords extérieurs 47 et 49 des parois 41 et 42. Ces cloisons métalliques et ces parois, ainsi assemblées, forment alors des cavités de réception 50 destinées à recevoir chacune un connecteur blindé 18. Dans l'exemple décrit, ces cavités de réception ont toutes des dimensions identiques, les cloisons métalliques 43 étant établies de manière à laisser entre elles un espacement à peine supérieur à la largeur d de la face d'accouplement 31 de chacun des connecteurs blindés 18. Dans ces conditions, lorqu'un connecteur blindé est engagé dans l'une de ces cavités pour être accolé au bloc collecteur 19, le blindage qui entoure ce connecteur frotte légèrement sur les deux cloisons qui délimitent cette cavité et se trouve ainsi mis en contact avec ces deux cloisons.

Dans l'exemple décrit, les éléments de contact 28 qui se trouvent à l'intérieur d'une même cavité sont disposés suivant deux colonnes, ces deux colonnes étant écartées l'une de l'autre d'une distance p, comme le montre la figure 3. Il faut cependant signaler que cette disposition n'est pas spécifique de la présente invention et que, dans un mode de réalisation plus général, ces éléments de contact pourraient être disposés suivant m colonnes, écartées les unes des autres d'une distance p, les éléments de contact 28 placés à l'intérieur d'une cavité de réception étant séparés de ceux situés dans la cavité voisine par une distance égale à kp, k étant un nombre entier, les connecteurs blindés étant naturellement conçus, tant au point de vue de leurs dimensions que de la disposition de leurs éléments de contact, de manière à répondre aux exigences du mode de réalisation choisi. En effet, pour des raisons d'économie, on est amené à utiliser des cloisons métalliques 43 dont l'épaisseur e est relativement petite, c'est-à-dire au plus égale à la distance p qui sépare deux colonnes d'éléments de contact, cette distance p étant, en général, inférieure à trois millimètres. On a alors trouvé que, pour satisfaire à cette condition, la face d'accouplement 31 des connecteurs blindés 18 devait avoir une largeur d conditionnée par la double inégalité suivante :

$$(m + k - 2)p < d < (m + k - 1)p$$

Par suite, si on désigne par j le jeu nécessaire au coulissement d'un connecteur blindé à l'intérieur d'une cavité de réception, l'épaisseur e de chacune des cloisons métalliques 43 est donnée par la relation :

$$e = (m + k - 1)p - d - j$$

C'est ainsi que, dans l'exemple décrit, où les éléments de contact situés dans une cavité de réception sont séparés de ceux situés dans la cavité voisine par une distance égale à 3p (ce qui donne : k = 3) et où on a par ailleurs : m = 2 et p = 2,54 mm, les connecteurs blindés doivent présenter une face d'accouplement dont la largeur d satisfasse à la double inégalité :

$$(2 + 3 - 2)\,2{,}54 < d < (2 + 3 - 1)\,2{,}54$$

soit : 7,62 mm < d < 10,16 mm

Pour les connecteurs blindés qui sont utilisés dans l'exemple décrit, cette largeur d est égale à 9 mm et le jeu j estimé nécessaire au coulissement de ces connecteurs dans les cavités de réception est pris égal à 0,16 mm. Dans ces conditions, l'épaisseur e des cloisons métallliques 43 est égale à :

$$e = (2 + 3 - 1)\,2{,}54 - 9 - 0{,}16$$

soit : e = 1 mm

On peut remarquer encore, en se référant aux figures 2A et 2B, que, pour la réalisation des cloisons 43, on utilise des pièces dont la section droite à sensiblement la forme d'un U, les portions 51 de ces pièces qui correspondent aux branches de ce U servant à assurer la fixation, par soudage, de ces pièces sur les deux parois 41 et 42. En outre, ces portions, qui ont une largeur t inférieure à la distance qui sépare deux cloisons 43 consécutives, introduisent, dans chaque cavité de réception, une dissymétrie et jouent, par conséquent, le rôle d'éléments de détrompage lors de l'introduction des connecteurs blindés dans ces cavités de réception. Bien entendu ces connecteurs blindés sont profilés, de manière connue, comme on le voit sur la figure 2B, de façon à venir s'adapter sur ces éléments de détrompage lors de leur engagement dans ces cavités.

On peut encore observer, en se référant à la figure 3, que l'ensemble de blindage 40 présente, au moins dans sa partie entourant le corps isolant du bloc collecteur 19, des dimensions inférieures à celles de l'ouverture 33 de la plaque d'enceinte 12 du châssis-support. En conséquence, cet ensemble de blindage est muni d'un plastron métallique 55 qui, comme on le voit sur les figures 2A et 2B, est profilé de façon à venir s'ajuster, avec un très faible jeu, sur les parois 41 et 42 de cet ensemble de blindage, ce plastron étant percé d'une fenêtre 56 pour le passage des cavités de réception 50, et étant dimensionné de façon à venir s'appliquer, lorsque les deux parties 19A et 19B du bloc collecteur sont emboîtées l'une dans l'autre, sur les régions de la plaque d'enceinte 12 qui, comme on le comprend en se référant à la figure 3, sont voisines de l'ouverture 33. Ainsi qu'on le voit sur la figure 3, ce plastron 55 est rendu solidaire de l'ensemble de blindage 40 au moyen de vis métalliques 57, ces vis assurant également la fixation de cet ensemble de blindage sur la partie 19B du bloc collecteur. D'autres vis conductrices 58 sont utilisées pour réaliser la fixation du plastron 55 sur la plaque d'enceinte 12. On comprend, dans ces conditions, que, lorsqu'un connecteur blindé 18 est introduit dans l'une des cavités de réception 50, le blindage de ce connecteur se trouve électriquement relié à la plaque d'enceinte 12, c'est-à-dire au châssis-support, par l'intermédiaire de l'ensemble de blindage 40, du plastron 55 et des vis 57 et 58. Il en résulte que les courants électriques parasites qui, sous l'action des rayonnements électromagnétiques régnant à l'extérieur du châssis-support, sont engendrés dans la gaine de blindage du câble qui est solidaire de ce connecteur blindé, s'écoulent vers la terre en passant successivement dans le blindage de ce connecteur, dans l'ensemble de blindage 40, dans le plastron 55 et dans la plaque d'enceinte 12, c'est-à-dire en empruntant un circuit non situé à l'intérieur du châssis-support. Par suite, aucun rayonnement électromagnétique n'est engendré à l'intérieur du châssis-support et les circuits électriques enfermés dans ce châssis se trouvent efficacement protégés.

Il y a lieu d'indiquer encore que, pour éviter aux éléments de contact 28 de subir, de façon trop importante, les effets des rayonnements électromagnétiques extérieurs, lorsque ces éléments de contact ne se trouvent pas connectés aux éléments de contact 36 des connecteurs blindés, les extrémités 37 de ces éléments de contact 28 se trouvent en retrait par rapport aux bords extérieurs 47 et 49 des parois 41 et 42, la distance f qui sépare ces extrémités du plan P qui passe par ces deux bords étant au moins égale au tiers de la longueur b de la face d'accouplement 31 des connecteurs blindés. Il faut signaler également que, dans un mode de réalisation plus particulièrement avantageux, les parois 41 et 42, ainsi que les cloisons 43, sont constituées d'un matériau inaltérable et conducteur de l'électricité. C'est ainsi que, dans l'exemple décrit, ces parois et ces cloisons sont réalisées en acier inoxydable.

Bien entendu, l'invention n'est nullement limitée aux modes de mise en oeuvre décrits et illustrés qui n'ont été donnés qu'à titre d'exemple. Au contraire, elle comprend tous les moyens constituant des équivalents techniques de ceux décrits et illustrés, considérés isolément ou en combinaison, et mis en oeuvre dans le cadre des revendications qui suivent.

## Revendications

1. Ensemble de blindage pour un bloc collecteur relié à un équipement électrique placé à l'intérieur d'un châssis, ce bloc collecteur comprenant un corps isolant allongé (23A, 23B) présentant une face d'accouplement (29) destinée à recevoir plusieurs connecteurs complémentaires blindés (18), ce corps isolant étant pourvu d'éléments de contact d'un premier type (28) qui, raccordés aux circuits dudit équipement électrique (10), sont établis de manière à pouvoir être connectés à des éléments de contact d'un second type (36) de chacun desdits connecteurs complémentaires, cet ensemble de blindage étant caractérisé en ce que, ledit corps isolant étant positionné, à l'intérieur dudit châssis, de telle sorte que ses éléments de contact (28) passent au travers d'une ouverture (33) pratiquée dans une plaque d'enceinte métallique (12) de ce châssis, il comporte :

 - d'une part deux parois métalliques (41, 42) recouvrant chacune respectivement chacune des deux faces (34, 35) de plus grandes dimensions qui, sur ce corps isolant, sont adjacentes à ladite face d'accouplement (29), ces deux parois s'étendant, de l'intérieur vers l'extérieur dudit châssis, de façon que leurs bords extérieurs (47, 49) qui sont parallèles à ladite plaque d'enceinte (12) dépassent les extrémités (37) des éléments de contact dudit corps isolant,
 - d'autre part une pluralité de cloisons métalliques (43) disposées entre ces deux parois (41, 42), perpendiculairement à celles-ci et à ladite face d'accouplement (29), ces cloisons s'étendant chacune, à partir de cette face, jusqu'aux dits bords extérieurs (47, 49) desdites parois, de manière à constituer avec ces parois une pluralité de cavités de réception (50) de connecteurs complémentaires blindés, chaque cavité étant dimensionnée de telle sorte que les parois et cloisons qui la délimitent viennent au contact du blindage du connecteur complémentaire qui est introduit dans cette cavité, cet ensemble de blindage étant relié électriquement à ladite plaque d'enceinte (12) par l'intermédiaire d'un élément conducteur (55) ne passant pas à l'intérieur de ce châssis.

2. Ensemble de blindage selon revendication 1, caractérisé en ce que, cet élément de blindage étant dimensionné de façon à passer librement dans l'ouverture (33) de la plaque d'enceinte (12), l'élément conducteur est constitué par un plastron métallique (55), profilé de façon à venir s'ajuster, avec un très faible jeu, sur les parois (41, 42) de cet ensemble de blindage, ce plastron étant pourvu d'une fenêtre (56) pour le passage des cavités de réception (50) et étant dimensionné de façon à venir s'appliquer sur la plaque d'enceinte (12) et à établir ainsi la liaison électrique entre cette plaque et cet élément de blindage.

3. Ensemble de blindage, selon l'une quelconque des revendications 1 et 2, caractérisé en ce que, chaque connecteur blindé (18) présentant une face d'accouplement (31) de forme rectangulaire, les deux parois (41, 42) de cet ensemble de blindage sont dimensionnées de telle sorte que le plan (P) qui passe par les bords extérieurs (47, 49) de ces parois est écarté des extrémités (37) des éléments de contact (28) du corps isolant (23A, 23B) d'une distance dont la valeur (f) est au moins égale au tiers de la longueur (b) de la face d'accouplement (31) de chaque connecteur blindé.

4. Ensemble de blindage selon l'une quelconque des revendications 1 à 3, caractérisé en ce que les éléments de contact (28) du corps isolant (23A, 23B) sont disposés, à l'intérieur de chaque cavité de réception (50) suivant m colonnes s'étendant chacune suivant une direction parallèle aux cloisons (43), ces colonnes étant espacées les unes des autres d'une distance p, les éléments de contact (28) situés dans chaque cavité de réception étant séparés de ceux situés dans la cavité voisine par une distance égale à kp, k étant un nombre entier.

5. Ensemble de blindage selon revendication 4, caractérisé en ce que les valeurs de m et de k sont prises égales, respectivement, à 2 et à 3.

6. Ensemble de blindage selon l'une quelconque des revendications 4 et 5, caractérisé en ce que, chaque connecteur blindé présentant une face d'accouplement (31), de forme rectangulaire, ayant, dans une direction perpendiculaire aux cloisons (43), une dimension (d) satisfaisant à la double inégalité :
$$(m + k - 2)p < d < (m + k - 1)p$$
ces cloisons (43) ont chacune une épaisseur dont la valeur e est donnée par la relation :
$$e = (m + k - 1)p - d - j$$
j représentant la valeur du jeu nécessaire au coulissement d'un connecteur blindé à l'intérieur d'une cavité de réception.

7. Ensemble de blindage selon revendication 6, caractérisé en ce que chacune des cloisons (43) a une épaisseur égale à 1 mm.

8. Ensemble de blindage selon l'une quelconque des revendications 1 à 7, caractérisé en ce que chacune des cloisons (43) est constituée d'une pièce dont la section droite a sensiblement la forme d'un U, les portions (51) de cette pièce qui correspondent aux branches de ce U ayant une longueur (t) inférieure à la distance qui sépare deux cloisons consécutives, ces portions constituant ainsi des moyens de détrompage pour les connecteurs blindés qui sont introduits dans les cavités de réception (50).

9. Ensemble de blindage selon l 'une quelconque des revendications 1 à 8, caractérisé en ce que les parois (41, 42) et les cloisons (43) sont réalisées en acier inoxydable.

10. Châssis-support d'équipement électrique, caractérisé en ce qu'il est pourvu, sur l'une au moins de ses plaques d'enceinte, d'au moins un ensemble de blindage selon l'une quelconque des revendications 1 à 9.

## Patentansprüche

1. Abschirmungseinheit für einen Anschlußblock, der mit einer innerhalb eines Kastens angeordneten elektrischen Anordnung verbunden ist, wobei dieser Anschlußblock einen langgestreckten isolierenden Körper (23A, 23B) umfaßt, der eine Anschlußfläche (29) aufweist, die dazu bestimmt ist, mehrere abgeschirmte, komplementäre Verbinder (18) aufzunehmen, wobei dieser isolierende Körper mit Kontaktelementen eines ersten Typs (28) versehen ist, die mit den Schaltungen der genannten elektrischen Anordnung (10) verbunden und so beschaffen sind, daß sie mit Kontaktelementen eines zweiten Typs (36) eines jeden der genannten komplementären Verbinder verbunden werden können, wobei diese Abschirmungseinheit dadurch gekennzeichnet ist, daß sie bei innerhalb des Kastens angeordnetem isolierenden Körper, derart, daß dessen Kontaktelemente (28) durch eine in einer metallischen Umschließungsplatte (12) dieses Kastens ausgebildete Öffnung (33) verlaufen, umfaßt:
   - einerseits zwei metallische Wände (41, 42), die jeweils eine der beiden Flächen (34, 35) mit den größten Abmessungen bedecken, welche an diesem isolierenden Körper an die genannte Anschlußfläche (29) angrenzen, wobei sich diese beiden Wände von innerhalb des Kastens nach außerhalb erstrecken, so daß ihre Außenkanten (47, 49), die zu der Umschließungsplatte (12) parallel sind, über die Enden (37) der Kontaktelemente des isolierenden Körpers hinausreichen,
   - andererseits mehrere Trennwände (43), die zwischen diesen beiden Wänden (41, 42) senkrecht zu diesen und zu der Anschlußfläche (29) angeordnet sind, wobei sich jede dieser Trennwände ausgehend von dieser Fläche bis zu den Außenkanten (47, 49) der genannten Wände erstreckt, derart, daß sie mit diesen Wänden mehrere Hohlräume (50) für die Aufnahme von abgeschirmten, komplementären Verbindern bilden, wobei jeder Hohlraum so bemessen ist, daß die sie begrenzenden Wände und Trennwände mit der Abschirmung des komplementären Verbinders in Kontakt gelangen, der in diesen Hohlraum eingeführt wird, wobei diese Abschirmungseinheit mit der genannten Umschließungsplatte (12) über ein Leiterelement (55), das nicht in das Innere dieses Kastens reicht, elektrisch verbunden ist.

2. Abschirmungseinheit gemäß Anspruch 1, dadurch gekennzeichnet, daß das Leiterelement dann, wenn das Abschirmungselement so bemessen ist, daß es in die Öffnung (33) der Umschließungskante (12) frei bewegt werden kann, von einer Metallschürze (55) gebildet ist, deren Profil so gestaltet ist, daß sie mit sehr geringem Spiel an die Wände (41, 42) dieser Abschirmungseinheit angepaßt werden kann, wobei diese Schürze mit einem Fenster (56) versehen ist, durch das die Aufnahmehohlräume (70) verlaufen können, und so bemessen ist, daß sie auf die Umschließungsplatte (12) drückt und somit die elektrische Verbindung zwischen dieser Platte und diesem Abschirmungselement herstellt.

3. Abschirmungseinheit gemäß einem der Ansprüche 1 und 2, dadurch gekennzeichnet, daß die beiden Wände (41, 42) dieser Abschirmungseinheit dann, wenn jeder abgeschirmte Verbinder (18) eine Anschlußfläche (31) von rechteckiger Form aufweist, so bemessen sind, daß die Ebene (P), die durch die Außenkanten (47, 49) dieser Wände verläuft, von den Enden (37) der Kontaktelemente (28) des isolierenden Körpers (23A, 23B) um eine Strecke beabstandet ist, dessen Wert (f) wenigstens gleich einem Drittel der Länge (b) der Anschlußfläche (31) eines jeden abgeschirmten Verbinders ist.

4. Abschirmungseinheit gemäß einem der Ansprüche 1 bis 3, dadurch gekennzeichnet, daß die Kontaktelemente (28) des isolierenden Körpers (23A, 23B) innerhalb eines jeden Aufnahmehohlraums (50) in m Spalten angeordnet sind, die sich jeweils in einer zu den Trennwänden (43) parallelen Richtung erstrecken und voneinander um eine Strecke p beabstandet sind, wobei die Kontaktelemente (28), die sich in jedem Aufnahmehohlraum befinden, von denjenigen, die sich im benachbarten Hohlraum befinden, um eine Strecke beabstandet sind, die gleich kp, wobei k eine ganze Zahl ist.

5. Abschirmungseinheit gemäß Anspruch 4, dadurch gekennzeichnet, daß die Werte von m und von k gleich 2 bzw. 3 gewählt sind.

6. Abschirmungseinheit gemäß einem der Ansprüche 4 und 5, dadurch gekennzeichnet, daß dann, wenn jeder abgeschirmte Verbinder eine Anschlußfläche (31) von rechteckiger Form aufweist, die in einer zu den Trennwänden (43) senkrechten Richtung eine Abmessung (d) besitzt, die die doppelte Ungleichheit:

$$(m + k - 2)p < d < (m + k - 1)p$$

erfüllt, diese Trennwände (43) jeweils eine Dicke besitzen, deren Wert e durch die Beziehung

$$e = (m + k - 1)p - d - j$$

gegeben ist, wobei j den Wert des für das Gleiten eines abgeschirmten Verbinders in den Aufnahmehohlraum erforderlichen Spiels darstellt.

7. Abschirmungseinheit gemäß Anspruch 6, dadurch gekennzeichnet, daß jede der Trennwände (43) eine Dicke besitzt, die 1 mm ist.

8. Abschirmungseinheit gemäß einem der Ansprüche 1 bis 7, dadurch gekennzeichnet, daß jede der Trennwände (43) von einem Teil gebildet ist, dessen Querschnitt im wesentlichen die Form eines U besitzt, wobei die Abschnitte (51) dieses Teils, die den Schenkeln dieses U entsprechen, eine Länge (t) besitzen, die kleiner als die Strecke ist, um die aufeinanderfolgende Trennwände beabstandet sind, wobei diese Abschnitte somit Unverwechselbarkeitsmittel für die abgeschirmten Verbinder bilden, die in die Aufnahmehohlräume (50) eingeführt werden.

9. Abschirmungseinheit gemäß einem der Ansprüche 1 bis 8, dadurch gekennzeichnet, daß die Wände (41, 42) und die Trennwände (43) aus nichtrostendem Stahl verwirklicht sind.

10. Chassis für elektrische Anordnung, dadurch gekennzeichnet, daß es an wenistens einer seiner Umschließungsplatten mit wenigstens einer Abschirmungseinheit gemäß einem der Ansprüche 1 bis 9 versehen ist.

## Claims

1. A screening assembly for a terminal block connected to a piece of electrical equipment placed inside a frame, this terminal block comprising an elongated insulating body (23A, 23B) having a coupling face (29) intended to receive several complementary screened connectors (18), this insulating body being provided with contact elements of a first type (28) which, when connected to the circuits of said piece of electrical equipment (10), are established in such a way as to be capable of connection to contact elements of a second type (36) of each of said complementary connectors, this screening assembly being characterised in that, said insulating body being positioned inside said frame such that its contact elements (28) pass through an aperture (33) made in a metal enclosure plate (12) of this frame, it comprises:

    - on the one hand, two metal walls (41, 42) each covering respectively each of the two faces (34, 35) with the largest dimensions which, on this insulating body, are adjacent to said coupling face (29), these two walls extending, from the inside towards the outside of said frame, such that their external edges (47, 49) which are parallel to said enclosure plate (12) project past the extremities (37) of the contact elements of said insulating body,

- on the other hand, a plurality of metal partitions (43) arranged between these two walls (41, 42), perpendicular to the latter and to said coupling face (29), these partitions each extending from this face as far as said external edges (47, 49) of said walls, so as to constitute, together with these walls, a plurality of reception cavities (50) for complementary screened connectors, each cavity having dimensions such that the walls and partitions which delimit it come into contact with the screening of the complementary connector which is inserted in this cavity, this screening assembly being electrically connected to said enclosure plate (12) through the intermediary of a conductor element (55) which does not pass inside this frame.

2. A screening assembly according to Claim 1, characterised in that, this screening element having dimensions so as to pass freely into the aperture (33) of the enclosure plate (12), the conductor element consists of a metal casing (55), shaped so as to fit with very little play over the walls (41, 42) of this screening assembly, this casing being provided with a window (56) for the passage of the reception cavities (50) and having dimensions so as to be applied to the enclosure plate (12) and thus to establish the electrical connection between this plate and this screening element.

3. A screening assembly according to any one of Claims 1 and 2, characterised in that, each screened connector (18) having a coupling face (31) of rectangular form, the two walls (41, 42) of this screening assembly have dimensions such that the plane (P) passing through the external edges (47, 49) of these walls is separated from the extremities (37) of the contact elements (28) of the insulating body (23A, 23B) by a distance, the value (f) of which is at least equal to a third of the length (b) of the coupling face (31) of each screened connector.

4. A screening assembly according to any one of Claims 1 to 3, characterised in that the contact elements (28) of the insulating body (23A, 23B) are arranged, inside each reception cavity (50), in m columns each extending in a direction parallel to the partitions (43), these columns being spaced from one another by a distance p, the contact elements (28) located in each reception cavity being separated from those located in the adjacent cavity by a distance equal to kp, k being a whole number.

5. A screening assembly according to Claim 4, characterised in that the values of m and k are taken to be equal, respectively, to 2 and 3.

6. A screening assembly according to any one of Claims 4 and 5, characterised in that, each screened connector having a coupling face (31) rectangular in form with, in a direction perpendicular to the partitions (43), a dimension (d) satisfying the double inequality:

$$(m + k - 2)p < d < (m + k - 1)p$$

these partitions (43) each have a thickness, the value e of which is given by the relationship:

$$e = (m + k - 1)p - d - j$$

j representing the value of the play necessary for a screened connector to slide inside a reception cavity.

7. A screening assembly according to Claim 6, characterised in that each of the partitions (43) has a thickness equal to 1 mm.

8. A screening assembly according to any one of Claims 1 to 7, characterised in that each of the partitions (43) consists of a part, the cross section of which is substantially U-shaped, the portions (51) of this part which correspond to the branches of the U having a length (t) less than the distance that separates two consecutive partitions, these portions thus constituting polarisation means for the screened connectors which are inserted into the reception cavities (50).

9. A screening assembly according to any one of Claims 1 to 8, characterised in that the walls (41, 42) and the partitions (43) are made of stainless steel.

10. A support frame for electrical equipment, characterised in that it is provided, on at least one of its enclosure plates, with at least one screening assembly according to any one of Claims 1 to 9.

FIG. 1

## FIG. 2A

FIG. 2B

FIG. 3

FIG. 4

EP 0 419 332 B1